(19) Europäisches Patentamt
European Patent Office
Office européen des brevets

(11) **EP 4 525 007 A1**

(12) **EUROPEAN PATENT APPLICATION**
published in accordance with Art. 153(4) EPC

(43) Date of publication:
**19.03.2025  Bulletin 2025/12**

(21) Application number: **23845032.4**

(22) Date of filing: **25.05.2023**

(51) International Patent Classification (IPC):
***H01F 27/28*** (2006.01)

(52) Cooperative Patent Classification (CPC):
**H01F 27/28; H01F 27/30; H01F 38/16; H02M 1/00;
H05K 7/20**

(86) International application number:
**PCT/CN2023/096207**

(87) International publication number:
**WO 2024/021818 (01.02.2024 Gazette 2024/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.07.2022  CN 202210891919**

(71) Applicant: **Huawei Technologies Co., Ltd.
Shenzhen, Guangdong 518129 (CN)**

(72) Inventors:
• **TAN, Wei
Shenzhen, Guangdong 518129 (CN)**
• **YANG, Heqian
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **PLANAR TRANSFORMER, POWER MODULE, AND POWER SUPPLY MODULE**

(57)    This application provides a planar transformer, a power module, and a power supply module. The planar transformer includes: a magnetic core, where a hole is formed on a surface of the magnetic core; and a PCB winding, where the PCB winding includes a first winding and a second winding, the first winding is disposed around at least one part of the magnetic core, a part of the first winding is disposed on the surface of the magnetic core, the magnetic core and the part of the first winding disposed on the surface of the magnetic core are disposed in a stacked manner, a part of the first winding is located in the hole, and the second winding is disposed on the magnetic core, where the first winding is one of a primary-side winding and a secondary-side winding, and the second winding is the other of the primary-side winding and the secondary-side winding. In this application, power density of the planar transformer can be increased.

FIG. 2

EP 4 525 007 A1

## Description

This application claims priority to Chinese Patent Application No. 202210891919.9, filed with the China National Intellectual Property Administration on July 27, 2022 and entitled "PLANAR TRANSFORMER, POWER MODULE, AND POWER SUPPLY MODULE", which is incorporated herein by reference in its entirety.

## TECHNICAL FIELD

This application relates to the field of energy technologies, and in particular, to a planar transformer, a power module, and a power supply module.

## BACKGROUND

With the development of communication, to increase a maximum amount of information carried by a communication device, capacity of the communication device usually needs to be expanded. When capacity of the communication device is expanded, output power of a power supply module that supplies power to the communication device also needs to be increased, but a size of the power supply module needs to be reduced or kept unchanged. To be specific, power density of the power supply module needs to be increased.

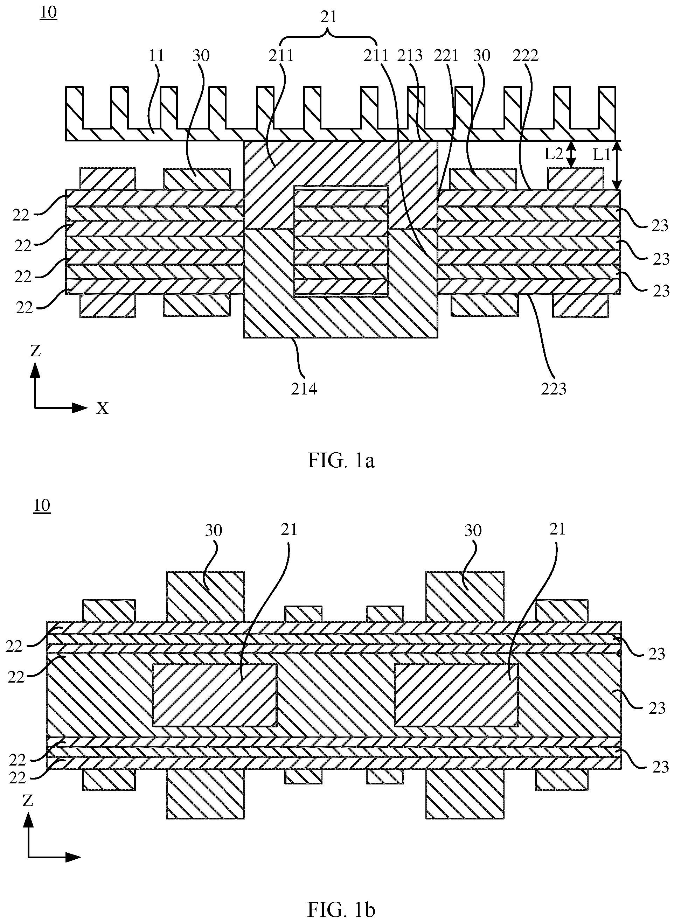

As shown in FIG. 1a, a power module 10, as a main component in the power supply module, includes a planar transformer 20 and a semiconductor device 30, where the planar transformer 20 includes a magnetic core 21 and a multi-layer printed circuit board (printed circuit board, PCB) winding 22, and the semiconductor device 30 is located on the top of the multi-layer PCB winding 22. A first through hole 221 is provided on the multi-layer PCB winding 22, the magnetic core 21 runs through the first through hole 221 of the multi-layer PCB winding 22 and is fastened to the PCB winding 22, a height of the magnetic core 21 is higher than a total thickness of the multi-layer PCB winding 22, and a top surface of the magnetic core is higher than a top surface of the semiconductor device.

Because the top surface of the magnetic core is higher than the top surface of the semiconductor device, space above the semiconductor device is wasted. Consequently, power density of the planar transformer is not high, and power density of the power module is not high.

## SUMMARY

To resolve the foregoing technical problem, this application provides a planar transformer, a power module, and a power supply module, to increase power density of the planar transformer.

This application provides a planar transformer, including a sub-transformer, where the sub-transformer includes: a magnetic core, where a hole is formed on a surface of the magnetic core; and a PCB winding, where the PCB winding includes a first winding and a second winding, the first winding is disposed around at least one part of the magnetic core, a part of the first winding is disposed on the surface of the magnetic core, the magnetic core and the part of the first winding disposed on the surface of the magnetic core are disposed in a stacked manner, a part of the first winding is located in the hole, and the second winding is disposed on the magnetic core, where the first winding is one of a primary-side winding and a secondary-side winding, and the second winding is the other of the primary-side winding and the secondary-side winding.

In the sub-transformer in the planar transformer in this application, the first winding is disposed around at least one part of the magnetic core, a part of the first winding is disposed on the surface of the magnetic core, and the magnetic core and the part of the first winding disposed on the surface of the magnetic core are disposed in a stacked manner. It can be learned that the first winding covers the surface of the magnetic core, in other words, the magnetic core does not protrude from the first winding. In this way, when the planar transformer is used in the power module, a switch tube may be fastened to the first winding, to reduce cases in which space is wasted because the magnetic core is higher than the first winding, thereby increasing power density of the planar transformer. In addition, a part of the first winding is disposed in the hole, so that a space size can be fully used to improve space utilization of the planar transformer, thereby improving power density of the planar transformer.

In some possible implementations, the magnetic core includes a first core body and a second core body that are disposed opposite to each other, and the hole is formed between the first core body and the second core body; and the first winding is disposed around the first core body. In this way, a winding manner of the first winding on the magnetic core is radial winding, so that radius effect can be alleviated, to reduce a loss of the first winding, thereby improving efficiency of the planar transformer.

In some possible implementations, at least one part of the second winding is located in the hole. In this way, in a height direction of the planar transformer, at least one part of the second winding is located in a height range in which the hole is located, so that window utilization of the magnetic core can be improved, to improve space utilization of the planar transformer, thereby improving power density of the planar transformer.

In some possible implementations, the hole is a through hole, a part of the second winding is located in the hole, and two ends of the second winding extend out of the hole. In this way, in a height direction of the planar transformer, the second winding is located in a height range in which the hole is located, so that window utilization of the magnetic core can be improved, to improve space utilization of the planar transformer, thereby improving power density of the planar transformer.

In some possible implementations, the sub-transformer further includes a third winding, the third winding is disposed around the second core body, a part of the third winding is disposed on a surface that is of the second core body and that is away from the first core body, and a part of the third winding is located in the hole. When the second winding is used as a primary-side winding, both the first winding and the third winding may be used as secondary-side windings. In this way, the planar transformer in this application includes one primary-side winding and two secondary-side windings. The third winding is disposed around at least one part of the magnetic core, a part of the third winding is disposed on a surface that is of the second core body and that is away from the first core body, and the magnetic core and the third winding are disposed in a stacked manner. Therefore, it can be learned that the third winding covers the surface of the magnetic core, in other words, the magnetic core does not protrude from the third winding. In this way, when the planar transformer is used in the power module, a switch tube may be fastened to the third winding, to reduce cases in which space is wasted because the magnetic core exceeds the third winding, thereby increasing power density of the planar transformer. In addition, a part of the third winding is disposed in the hole, so that a space size can be fully used to improve space utilization of the planar transformer, thereby improving power density of the planar transformer.

In some possible implementations, the second winding is located between the first winding and the third winding. In this way, the second winding is not located in a space range enclosed by the first winding. Therefore, cases in which mounting is inconvenient due to small mounting space in a process in which the second winding is fastened to the magnetic core after the first winding is fastened to the magnetic core can be reduced. To be specific, the foregoing solution facilitates fastening the first winding and the second winding to the magnetic core. Similarly, the second winding is not located in a space range enclosed by the third winding. Therefore, cases in which mounting is inconvenient due to small mounting space in a process in which the second winding is fastened to the magnetic core after the third winding is fastened to the magnetic core can be reduced. To be specific, the foregoing solution facilitates fastening the third winding and the second winding to the magnetic core.

In some possible implementations, the hole is the through hole, and two ends of the first winding extend from two ends of the hole and are wound around the first core body. In this way, a winding manner of the first winding on the magnetic core is radial winding, so that radius effect can be alleviated, to reduce a loss of the first winding, thereby improving efficiency of the planar transformer.

In some possible implementations, the hole is the through hole, and two ends of the third winding extend from two ends of the hole and are wound around the second core body. In this way, a winding manner of the third winding on the magnetic core is radial winding, so that radius effect can be alleviated, to reduce a loss of the third winding, thereby improving efficiency of the planar transformer.

In some possible implementations, there are a plurality of sub-transformers, and second windings of the plurality of sub-transformers are all connected in series. In this way, a transformation ratio and output power of the planar transformer can be improved.

In some possible implementations, the plurality of sub-transformers are located at a same layer and are sequentially arranged in a first direction, and holes in at least two of the plurality of sub-transformers are in communication with each other. When holes in the two sub-transformers are in communication with each other, first windings of the two sub-transformers may be located at a same layer. Therefore, the first windings that are located at the same layer and that are interconnected may be manufactured as a whole. In other words, the first winding is manufactured by using one PCB. In this way, assembly steps can be reduced, so as to simplify the process.

In some possible implementations, the plurality of sub-transformers are located at a same layer and are arranged in a rectangular array, holes in the plurality of sub-transformers in a first direction are all in communication with each other, holes in the plurality of sub-transformers in a second direction are all parallel to each other, and the second direction is perpendicular to the first direction. When holes in the two sub-transformers are in communication with each other, first windings of the two sub-transformers may be located at a same layer. Therefore, the first windings that are located at the same layer and that are interconnected may be manufactured as a whole. In other words, the first winding is manufactured by using one PCB. In this way, assembly steps can be reduced, so as to simplify the process.

In some possible implementations, the plurality of sub-transformers are located at a same layer and arranged in a cross-shaped array. In this way, a structure of the planar transformer is more compact, and is applicable to a case in which a size in a direction of the power module is limited and larger mounting space cannot be provided for the planar transformer.

In some possible implementations, the plurality of sub-transformers are disposed in a stacked manner. The structure is applicable to a case in which mounting space of a same layer in the power module is small.

This application further provides a power module, including any one of the foregoing planar transformers. The power module can achieve all the effects of the planar transformer.

In some possible implementations, the power module further includes a first switch tube, a first electrode and a second electrode of the first switch tube are respectively connected to two ends of the first winding of the sub-transformer, the first switch tube is fastened to the first winding, and the first switch tube, a part of the first winding, and the magnetic core are disposed in a stacked manner. In this way, space utilization of the power module can be improved. In addition, a part of the first winding is disposed on the surface of the magnetic core, and the magnetic core and the first winding are disposed in a stacked manner. It can be learned that the first winding covers the first surface of the magnetic core, in other words, in the height direction of the planar transformer, the first winding is higher than the first surface of the magnetic core. In this way, cases in which space is wasted because the magnetic core is higher than the first winding are reduced, so that power density of the planar transformer can be increased. In addition, the second part of the first winding is disposed in the hole, so that a space size can be fully used to improve space utilization of the planar transformer, thereby improving power density of the planar transformer. In addition, a distance between the first switch tube and a heat sink can be shortened, that is, a heat dissipation path can be shortened, so as to reduce thermal resistance, thereby improving thermal derating of the power module.

In some possible implementations, the power module further includes a second switch tube, where a first electrode and a second electrode of the second switch tube are respectively connected to the two ends of the third winding, the second switch tube is fastened to the third winding, and the second switch tube, a part of the third winding, and the magnetic core are disposed in a stacked manner. A part of the third winding is disposed on the surface of the magnetic core, and the magnetic core and the third winding are disposed in a stacked manner. Therefore, it can be learned that the third winding covers the surface of the magnetic core. In this way, cases in which space is wasted because the magnetic core exceeds the third winding are reduced, so that power density of the planar transformer can be increased. In addition, a part of the third winding is disposed in the hole, so that a space size can be fully used to improve space utilization of the planar transformer, thereby improving power density of the planar transformer.

This application further provides a power supply module, including any one of the foregoing power modules. The power supply module can achieve all the effects of the power module.

This application further provides an electronic device, including the foregoing power supply module. The electronic device can achieve all effects of the power module.

## BRIEF DESCRIPTION OF DRAWINGS

To describe the technical solutions in embodiments of this application more clearly, the following briefly describes the accompanying drawings required for describing embodiments of this application. Apparently, the accompanying drawings in the following description show merely some embodiments of this application, and a person of ordinary skill in the art may still derive other drawings from these accompanying drawings without creative efforts.

FIG. 1a is a schematic of a structure of a power module in a related technology;
FIG. 1b is a schematic of a structure of a power module in another related technology;
FIG. 2 is a schematic of a structure of a power module according to an embodiment of this application;
FIG. 3 is a schematic of a structure of a planar transformer in the power module shown in FIG. 2 from a first view angle;
FIG. 4 is a schematic of a structure of a magnetic core in the planar transformer shown in FIG. 3;
FIG. 5 is a schematic of a structure of the planar transformer shown in FIG. 3 from a second view angle;
FIG. 6 is a cutaway drawing of the planar transformer shown in FIG. 3;
FIG. 7 is a cutaway drawing of AA in FIG. 5;
FIG. 8 is a schematic of a structure of a power module according to another embodiment of this application;
FIG. 9 is a schematic of a structure of a planar transformer in the power module shown in FIG. 8;
FIG. 10 is a cutaway drawing of the power module shown in FIG. 8;
FIG. 11a is a schematic of a structure of a power module according to another embodiment of this application;
FIG. 11b is a diagram of a simulation experiment result;
FIG. 12 is a schematic of a structure of a power module according to another embodiment of this application;
FIG. 13 is a schematic of a structure of a power module according to another embodiment of this application;
FIG. 14 is a schematic of a structure of a power module according to another embodiment of this application.

Reference numerals: 10-power module; 11-heat sink; 20-planar transformer; 200-sub-transformer; 201-first sub-transformer; 202-second sub-transformer; 203-third sub-transformer; 204-fourth sub-transformer; 205-fifth sub-transformer; 21-magnetic core; 211-core body; 213-top surface of the magnetic core; 214-bottom surface of the magnetic core; 215-first surface; 216-second surface; 217-third surface; 218-fourth surface; 219-hole; 2110-first core body; 2112-second core body; 22-PCB winding; 221-first through hole; 222-top surface of the PCB winding; 223-bottom surface of the PCB winding; 224-first winding; 2241-first part; 2242-second part; 2243-third part; 2244-fourth part; 2245-fifth part; 2246-first opening; 225-second winding; 226-third winding; 2261-first part; 2262-second part; 2263-third part; 2264-fourth part; 2265-fifth part; 2266-second opening; 23-dielectric layer; 30-semiconductor device; 31-first switch tube; 32-second switch tube; 33-third switch tube;

40-capacitor.

## DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object, a second target object, and the like are used for distinguishing between different target objects, but are not used for describing a specific order of the target objects.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the word such as "example" or "for example" is intended to present a relative concept in a specific manner.

In descriptions of embodiments of this application, unless otherwise stated, "plurality of" means two or more than two. For example, a plurality of processing units mean two or more processing units, and a plurality of systems mean two or more systems.

With the development of communication, to increase a maximum amount of information carried by a communication device, capacity of the communication device usually needs to be expanded. When capacity of the communication device is expanded, output power of a power supply module that supplies power to the communication device also needs to be increased, but a size of the power supply module needs to be reduced or kept unchanged. To be specific, power density of the power supply module needs to be increased.

The power supply module includes a power supply and a control module. For ease of description, three directions may be defined: a first direction (X direction), a second direction (Y direction), and a third direction (Z direction), where the X direction represents a length direction of the power module, the Y direction represents a width direction of the power module, and the Z direction represents a height direction of the power module.

The power module 10 includes a planar transformer 20 and a semiconductor device 30. The planar transformer 20 generally includes a magnetic core 21 and a winding. The magnetic core 21 generally uses a small-sized E-type, ring permanent magnet (Ring Permanent Magnet, RM)-type, or ring-type ferrite magnetic core 21. These types of magnetic cores 21 are generally made of a high-frequency power ferrite material, and have a low magnetic core loss at a high frequency. The winding is formed through lap-winding of a multi-layer PCB, and the multi-layer winding is stacked on the high-frequency magnetic core 21 to form a magnetic loop of the transformer.

In a related technology, as shown in FIG. 1a, the planar transformer 20 includes the magnetic core 21 and the multi-layer PCB winding 22, where the PCB winding 22 has four layers in total, a dielectric layer 23 is disposed between every two layers of the PCB winding 22, and a material of the dielectric layer 23 may be polypropylene (Polypropylene, PP). A first through hole 221 extending in the Z direction is provided on the multi-layer PCB winding 22 and the plurality of dielectric layers 23. The magnetic core 21 is of a cuboid structure as a whole. The magnetic core 21 includes two core bodies 211 that are placed opposite to each other. The two core bodies 211 are fastened in pairs, run through the first through hole 221 of the multi-layer PCB winding 22, and are fastened to the PCB winding 22. In addition, a total height of the magnetic core 21 is greater than a total height of the multi-layer PCB winding 22 and the plurality of dielectric layers 23. Two end surfaces of the magnetic core 21 both protrude from the multi-layer PCB winding 22. To be specific, a top surface 213 of the magnetic core is higher than a top surface 222 of the PCB winding, and a bottom surface 214 of the magnetic core is lower than a bottom surface 223 of the PCB winding. In the related technology, the top surface 213 of the magnetic core is higher than the top surface 222 of the PCB winding by a size L1: 3 mm. It should be noted that, the "total height" may be a total size in the Z direction.

The semiconductor device 30 may include a switch tube, where the switch tube may be a triode. For example, the switch tube may be a metal-oxide-semiconductor field-effect transistor (Metal Oxide Semiconductor, MOS). As shown in FIG. 1a, there are a plurality of semiconductor devices 30, and the plurality of semiconductor devices 30 are respectively located on a bottom surface 223 of the PCB winding and a top surface 222 of the PCB winding. A total height of the semiconductor device 30 is 1 mm. Because the top surface 213 of the magnetic core is higher than the top surface 222 of the PCB winding by the size L1: 3 mm, the top surface 213 of the magnetic core is higher than the top surface of the switch tube by a size L2: 2 mm. Similarly, the bottom surface of the magnetic core 21 is also lower than the bottom surface of the semiconductor device 30 by 2 mm. As a result, space of the semiconductor device 30 is wasted. Consequently, power density of the planar transformer 20 is not high, and power density of the power module 10 is not high. In addition, because the semiconductor device 30 is a device with high thermal consumption, a heat sink 11 is required for heat dissipation. The heat sink 11 needs to be higher than the top surface 213 of the magnetic core in height. Therefore, a distance between the switch tube and the heat sink 11 is greater than 2 mm, to be specific, the distance between the switch tube and the heat sink 11 is long. As a result, a heat dissipation path of the semiconductor device 30 is long. Consequently, thermal derating of the semiconductor device 30 is reduced, and thermal derating of the power supply module is further reduced.

In another technology, as shown in FIG. 1b, a planar transformer 20 includes three dielectric layers 23 that are disposed in a stacked manner and a multi-layer PCB winding 22, a magnetic core 21 is wrapped inside the middle dielectric layer, and the multi-layer PCB winding 22 is located on two sides of the middle dielectric layer 23. It can be learned from FIG. 1b that, because the magnetic core 21 is wrapped inside the middle dielectric layer 23, the entire planar transformer 20 is thick. Consequently, a size of the planar transformer 20 is increased and power density of the planar transformer 20 is further reduced.

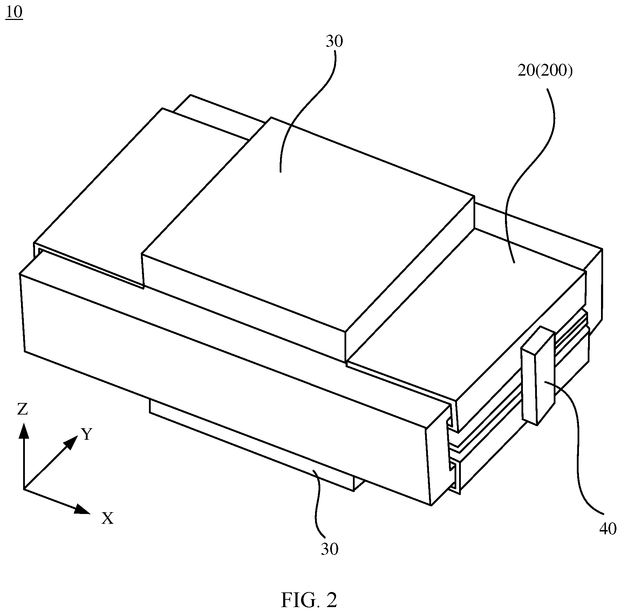

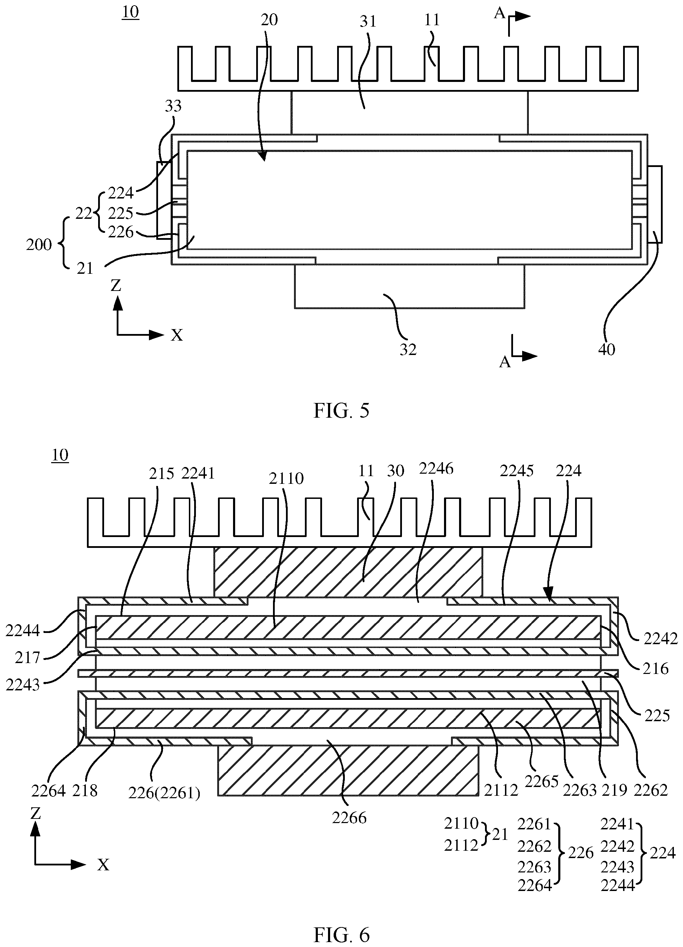

Based on this, as shown in FIG. 2 and FIG. 5, an embodiment of this application provides a power module. The power module includes a planar transformer 20, a semiconductor device 30, and a capacitor 40, to increase power density of the planar transformer 20.

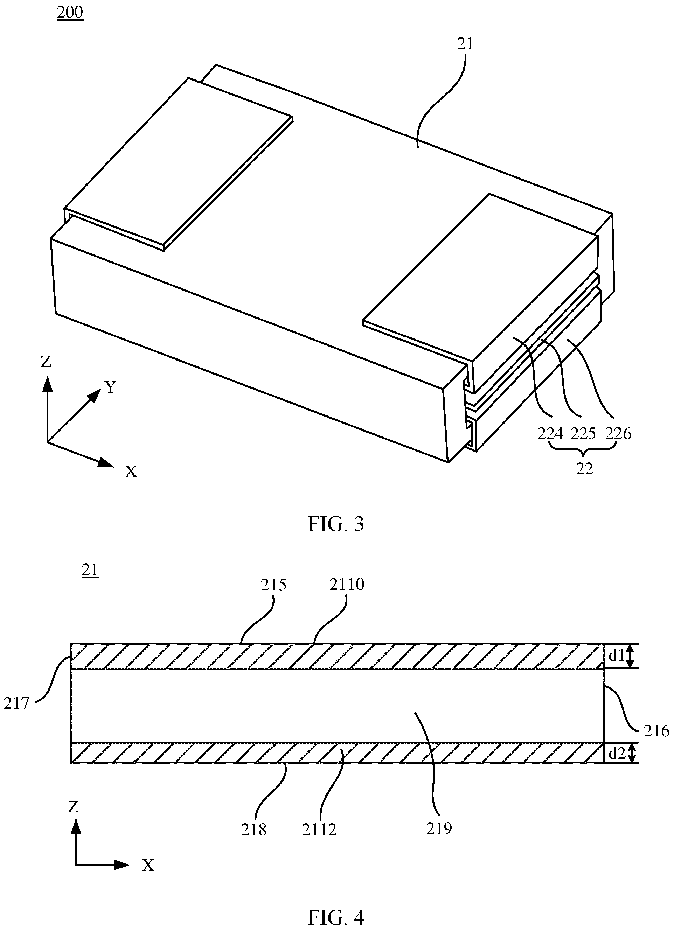

As shown in FIG. 2, the planar transformer 20 may include a sub-transformer 200. As shown in FIG. 3, the sub-transformer 200 includes a magnetic core 21 and a PCB winding 22.

As shown in FIG. 4, the magnetic core 21 has a first surface 215, a second surface 216, a second surface 216, and a fourth surface 218. The first surface 215 and the fourth surface 218 are two opposite surfaces, the second surface 216 and the third surface 217 are two opposite surfaces, and the first surface 215 and the fourth surface 218 are located between the second surface 216 and the third surface 217. A hole 219 that runs through to the third surface 217 is formed on the second surface 216. It should be noted that, in a possible implementation, the magnetic core 21 may be formed by connecting two components. For example, the magnetic core 21 may be formed by fastening and connecting two core bodies with U-shaped cross-sections. The connection herein may be assembly or welding. The two core bodies may be respectively named a first core body 2110 and a second core body 2112. In another possible implementation, the magnetic core 21 may be of an integrally formed structure. For example, the magnetic core 21 may be obtained by processing the hole 219 in a magnetic core with a rectangular surface.

As shown in FIG. 3 and FIG. 5, the PCB winding 22 includes a first winding 224, a second winding 225, and a third winding 226. In this embodiment, the first winding 224 and the third winding 226 may be secondary-side windings, and the second winding 225 may be a primary-side winding. In another embodiment, the first winding 224 and the third winding 226 may be primary-side windings, and the second winding 225 may be a secondary-side winding.

As shown in FIG. 6, the first winding 224 is disposed around a part of the magnetic core 21. Specifically, the first winding 224 may be disposed around the first core body 2110. For example, two ends of the first winding 224 extend from two ends of the hole 219 and are wound around the first core body 2110. It may be understood that a winding center of the first winding 224 may extend in a Y direction. In a possible implementation, the two ends of the first winding 224 extend to the first surface 215, and a first opening 2246 is provided between the two ends of the first winding 224. For example, the first winding 224 includes a first part 2241, a second part 2242, a third part 2243, a fourth part 2244, and a fifth part 2245. The first part 2241 may include one layer of PCB and a winding disposed on the PCB. The second part 2242, the third part 2243, the fourth part 2244, and the fifth part 2245 may all use a same structure as the first part 2241.

As shown in FIG. 6, the first part 2241 is disposed on the first surface 215. That the first part 2241 is disposed on the first surface 215 may mean that the first part 2241 is in direct contact with the first surface 215; or may mean that the first part 2241 is connected to the first surface 215 by using an intermediate connecting piece, for example, may be connected by using a dielectric layer 23, where a material of the dielectric layer may be PP; or may mean that there is a gap between the first part 2241 and the first surface 215, and no component is disposed in the gap, but the gap is filled with air.

As shown in FIG. 6, the fifth part 2245 is also disposed on the first surface 215, and the fifth part 2245 and the first part 2241 are located on two opposite ends of the first surface 215. Same as a meaning of that the first part 2241 is disposed on the first surface 215, that the fifth part 2245 is disposed on the first surface 215 may mean that the fifth part 2245 is in direct contact with the first surface 215; or the fifth part 2245 is connected to the first surface 215 by using an intermediate connecting piece; or there is a gap between the fifth part 2245 and the first surface 215, and no component is disposed in the gap.

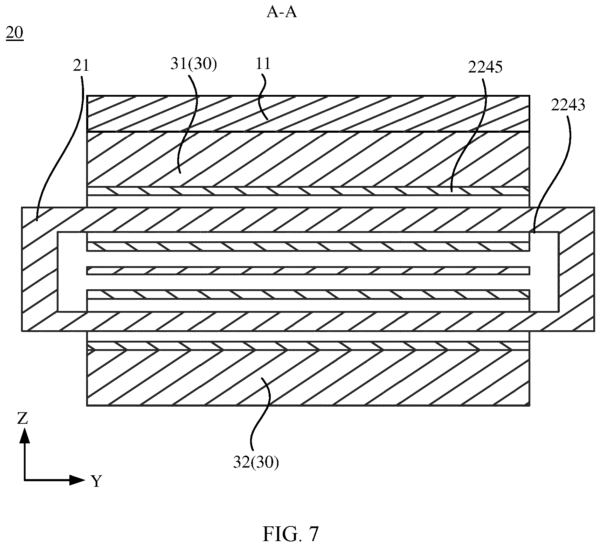

As shown in FIG. 6, the third part 2243 runs through the hole 219, a part of the third part 2243 is located in the hole 219, two ends of the third part 2243 extend out of the two ends of the hole 219, and the third part 2243 is opposite to the first part 2241. As shown in FIG. 6, a size of the third part 2243 in the X direction is greater than a sum of a size of the first part 2241 in the X direction and a size of the fifth part 2245 in the X direction. As shown in FIG. 7, sizes of the third part 2243 and the fifth part 2245 in the X direction may also be the same. Sizes of the third part 2243 and the first part 2241 in the X direction may also be the same.

As shown in FIG. 6, the second part 2242 is disposed on the second surface 216, the fourth part 2244 is disposed on the third surface 217, the second part 2242 is opposite to the fourth part 2244, two ends of the second part 2242 are respectively connected to the fifth part 2245 and the third part 2243, and two ends of the fourth part 2244 are respectively connected to the first part 2241 and the third part 2243. Sizes of the second part 2242 and the fourth part 2244 in the Z direction may be the same. In this way, a winding manner of the first winding 224 on the magnetic core 21 is radial winding, so that radius effect can be alleviated, to reduce a loss of the first winding 224, thereby improving efficiency of the planar transformer 20.

It should be noted that, same as the meaning of that the first part 2241 is disposed on the first surface 215, that the second part 2242 is disposed on the second surface 216 may mean that the second part 2242 is in direct contact with the second surface 216; or the second part 2242 is connected to the second surface 216 by using an intermediate connecting piece; or there is a gap between the second part 2242 and the second surface 216, and no component is disposed in the gap. That the fourth part 2244 is disposed on the third surface 217 may mean that the fourth part 2244 is in direct contact with the third surface 217; or the fourth part 2244 is connected to the third surface 217 by using an intermediate connecting piece; or there is a gap between the fourth part 2244 and the third surface 217, and no component is disposed in the gap.

As shown in FIG. 6, in the sub-transformer 200 of the planar transformer 20 in this application, the first winding 224 is disposed around a part of the magnetic core 21, and the first part 2241 and the fifth part 2245 of the first winding 224 are disposed on the first surface 215. In this way, the magnetic core 21 and the first part 2241 of the first winding 224 are disposed in a stacked manner, and the magnetic core and the fifth part 2245 of the first winding 224 are also disposed in a stacked manner. It can be learned that the first winding 224 covers the first surface 215 of the magnetic core 21. In other words, in the Z direction, the magnetic core 21 does not protrude from the first winding 224. In this way, a switch tube may be fastened to the first winding 224, to reduce cases in which space is wasted because the magnetic core 21 is higher than the first winding 224, thereby increasing power density of the planar transformer 20. In addition, the second part 2242 of the first winding 224 is disposed in the hole 219, so that a space size can be fully used to improve space utilization of the planar transformer 20, thereby improving power density of the planar transformer 20.

As shown in FIG. 6, the second winding 225 is disposed on the magnetic core 21, the second winding 225 may include one layer of PCB and a winding disposed on the PCB, a part of the second winding 225 is located in the hole 219, and two ends of the second winding 225 extend out of the hole 219 and extend. In this way, in a height direction of the planar transformer 20, at least one part of the second winding 225 is located in a height range in which the hole 219 is located, so that window utilization of the magnetic core 21 can be improved, to improve space utilization of the planar transformer 20, thereby improving power density of the planar transformer 20. The height direction may be the Z direction.

As shown in FIG. 6, the third part 2243 of the first winding 224 is closer to the first surface 215 than the second winding 225. In this way, the second winding 225 is not located in a space range enclosed by the first winding 224. Therefore, cases in which mounting is inconvenient due to small mounting space in a process in which the second winding 225 is fastened to the magnetic core 21 after the first winding 224 is fastened to the magnetic core 21 can be reduced. To be specific, the foregoing solution facilitates fastening the first winding 224 and the second winding 225 to the magnetic core 21.

As shown in FIG. 6, the third winding 226 is disposed around a part of the magnetic core 21. Specifically, the third winding 226 may be disposed around the second core body 2112. For example, two ends of the third winding 226 extend from the two ends of the hole 219 and surround the second core body 2112. It may be understood that a winding center of the third winding 226 may be the Y axis. In a possible implementation, the two ends of the third winding 226 extend to the fourth surface 218, and a second opening 2266 is provided between the two ends of the third winding 226. The third winding 226 includes a first part 2261, a second part 2262, a third part 2263, a fourth part 2264, and a fifth part 2265. The first part 2261 may include one layer of PCB and a winding disposed on the PCB. The second part 2262, the third part 2263, the fourth part 2264, and the fifth part 2265 may all use a same structure as the first part 2261.

As shown in FIG. 6, that the first part 2261 is disposed on the fourth surface 218 may mean that the first part 2261 is in direct contact with the fourth surface 218; or may mean that the first part 2261 is connected to the fourth surface 218 by using an intermediate connecting piece, for example, may be connected by using a dielectric layer 23; or may mean that there is a gap between the first part 2261 and the fourth surface 218, and no component is disposed in the gap, but the gap is filled with air.

The fifth part 2265 is also disposed on the fourth surface 218, and the fifth part 2265 and the first part 2261 are located on two opposite ends of the fourth surface 218.

As shown in FIG. 6, the third part 2263 runs through the hole 219, a part of the third part 2263 is located in the hole 219, two ends of the third part 2263 extend out of the two ends of the hole 219, and the third part 2263 is opposite to the first part 2261. As shown in FIG. 6, a size of the third part 2263 in the X direction is greater than a sum of a size of the first part 2261 in the X direction and a size of the fifth part 2265 in the X direction.

As shown in FIG. 7, sizes of the third part 2263 and the first part 2261 in the X direction may also be the same.

As shown in FIG. 6, the second part 2262 is disposed on the second surface 216, the fourth part 2264 is disposed on the third surface 217, the second part 2262 is opposite to the fourth part 2264, two ends of the second part 2262 are respectively connected to the fifth part 2265 and the third part 2263, and the two ends of the second part 2262 are respectively connected to the first part 2261 and the third part 2263. In this way, a winding manner of the third winding 226 on the magnetic core 21 is radial winding, so that radius effect can be alleviated, to reduce a loss of the third winding 226, thereby improving efficiency of the planar transformer 20.

As shown in FIG. 6, the third part 2263 of the third winding 226 is closer to the fourth surface 218 than the second winding 225. In this way, the second winding 225 is located between the first winding 224 and the third winding 226. The second winding 225 is not located in a space range enclosed by the third winding 226. Therefore, cases in which mounting is inconvenient due to small mounting space in a process in which the second winding 225 is fastened to the magnetic core 21 after the third winding 226 is fastened to the magnetic core 21 can be reduced. To be specific, the foregoing solution facilitates fastening the third winding 226 and the second winding 225 to the magnetic core 21.

As shown in FIG. 5, the semiconductor device 30 may include a first switch tube 31, a second switch tube 32, and a third switch tube 33. In this embodiment, there may be one first switch tube 31 and one second switch tube 32, and there may be two third switch tubes 33.

The first switch tube 31, the second switch tube 32, and the third switch tube 33 may all be triodes. For example, the first switch tube 31 and the second switch tube 32 may both be MOS transistors.

As shown in FIG. 6, the first winding 224 is connected to the first switch tube 31, and the first switch tube 31 is connected to an output end of the planar transformer 20. The first switch tube 31 is fastened to the first part 2241 and the fifth part 2245 of the first winding 224, the first switch tube 31 and the first part 2241 of the first winding 224 are disposed in a stacked manner, and the first switch tube 31 and the fifth part 2245 of the first winding are also disposed in a stacked manner. In this way, the magnetic core 21, the first winding 224, and the first switch tube 31 are disposed in a stacked manner, so that space utilization of the power module can be improved. In addition, because the first winding 224 does not protrude from the first surface 215 of the magnetic core 21, a distance between the first switch tube 31 and the heat sink 11 can be shortened, that is, a heat dissipation path can be shortened, so as to reduce thermal resistance, thereby improving thermal derating of the power module.

The first switch tube 31 may perform a rectification function. Because the first switch tube 31 is connected to the first winding 224, when the first winding 224 is the first switch tube 31, the first switch tube 31 may perform a secondary-side rectification function.

As shown in FIG. 6, the third winding 226 is connected to the second switch tube 32, and the second switch tube 32 is connected to the output end of the planar transformer 20. The second switch tube 32 is fastened to the first part 2261 and the fifth part 2265 of the third winding 226, the second switch tube 32 and the first part 2261 of the third winding 226 are disposed in a stacked manner, and the second switch tube 32 and the fifth part 2265 of the third winding 226 are also disposed in a stacked manner. In this way, the magnetic core 21, the third winding 226, and the second switch tube 32 are disposed in a stacked manner, so that space utilization of the power module can be improved. In addition, because the third winding 226 does not protrude from the fourth surface 218 of the magnetic core 21, a distance between the second switch tube 32 and the heat sink 11 can be shortened, that is, a heat dissipation path can be shortened, so as to reduce thermal resistance, thereby improving thermal derating of the power module.

The second switch tube 32 may perform a rectification function. Because the second switch tube 32 is connected to the third winding 226, when the third winding 226 is a secondary-side winding, the second switch tube 32 may perform a secondary-side rectification function.

As shown in FIG. 5, the third switch tube 33 may be fastened to one side of the sub-transformer 200, the third switch tube 33 and the capacitor 40 are respectively fastened to two opposite sides of the sub-transformer 200, and the third switch tube 33 is connected to the second winding 225 of the sub-transformer 200. When the second winding 225 is a primary-side winding, the third switch tube 33 may perform a primary-side rectification function.

In addition, the planar transformer 20 may be manufactured in a back-end assembly manner. For example, as shown in FIG. 6, the first part 2241, the second part 2242, the third part 2243, the fourth part 2244, and the fifth part 2245 of the first winding 224, the magnetic core 21, the second winding 225, and the first part 2261, the second part 2262, the third part 2263, the fourth part 2264, and the fifth part 2265 of the third winding 226 are separately manufactured, and then the foregoing parts are assembled together, to complete manufacturing the sub-transformer 200, thereby reducing the manufacturing process difficulty of the sub-transformer 200.

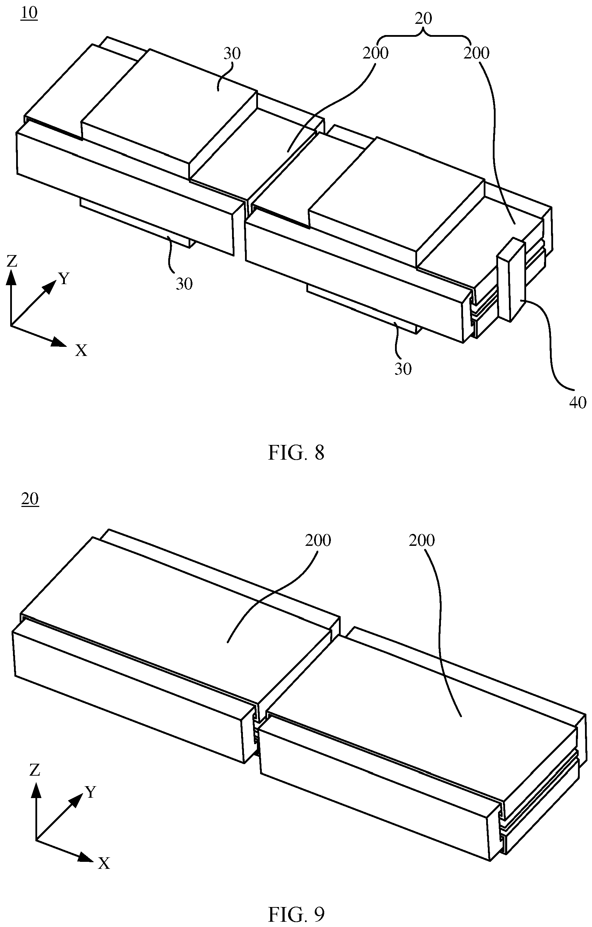

In another embodiment, as shown in FIG. 8, a difference between the embodiment shown in FIG. 8 and the embodiment shown in FIG. 3 lies in that quantities of sub-transformers 200, first switch tubes 31, and second switch tubes 32 are different. As shown in FIG. 3, the planar transformer 20 includes one sub-transformer 200. In this embodiment, the planar transformer 20 includes a plurality of sub-transformers 200, and correspondingly, there are a plurality of first switch tubes 31 and a plurality of second switch tubes 32. In a possible implementation, structures of all sub-transformers 200 may be the same. In another embodiment, structures of the plurality of sub-transformers 200 are all different. Alternatively, some sub-transformers 200 have a same structure, and other sub-transformers 200 have different structures. For example, in FIG. 9, the planar transformer 20 may include two sub-transformers 200, and structures of the two sub-transformers 200 are the same.

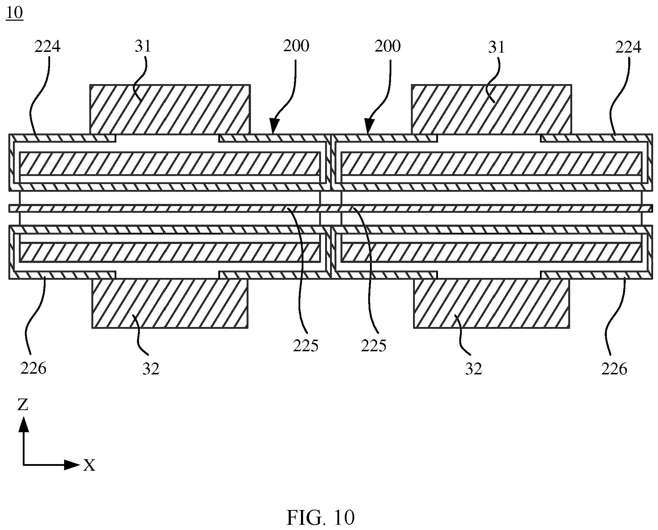

As shown in FIG. 10, second windings 225 of the plurality of sub-transformers 200 are all connected in series. For example, the second windings 225 of the plurality of sub-transformers 200 are sequentially connected. In this way, a transformation ratio and output power of the planar transformer 20 can be improved.

As shown in FIG. 10, the plurality of sub-transformers 200 are located at a same layer and are sequentially arranged in the X direction, and holes 219 in at least two of the plurality of sub-transformers 200 are in communication with each other. When the holes 219 in two sub-transformers 200 are in communication with each other, second windings 225 of the two sub-transformers 200 may be located at a same layer. Therefore, the first windings 224 that are located at the same layer and that are interconnected may be manufactured as a whole. In other words, the first winding 224 is manufactured by using one PCB. In this way, assembly steps can be reduced, so as to simplify the process.

In this embodiment, as shown in FIG. 10, there are two sub-transformers 200, and the holes 219 of the two sub-transformers 200 are in communication with each other. In another embodiment, when there are four sub-transformers 200, the holes 219 of the four sub-transformers 200 are all in communication with each other. In the four sub-transformers 200, the holes 219 of some sub-transformers 200 are all in communication with each other, and the holes 219 of the other sub-transformers 200 are not in communication with each other.

As shown in FIG. 10, each sub-transformer 200 corresponds to one first switch tube 31 and one second switch tube 32. In other words, a quantity of first switch tubes 31 and a quantity of second switch tubes 32 are both the same as a quantity of sub-transformers 200. Each first winding 224 is connected to each first switch tube 31 in a one-to-one correspondence, and each first switch tube 31 is connected to an output end of the planar transformer 20.

As shown in FIG. 10, each third winding 226 is connected to each second switch tube 32 in a one-to-one correspondence, and each second switch tube 32 is connected to the output end of the planar transformer 20.

In this embodiment, both the first winding 224 and the third winding 226 are secondary-side windings, and the second winding 225 is a primary-side winding. The first switch tubes 31 connected to the first windings 224 in the sub-transformers 200 are all connected in parallel, the second switch tubes 32 connected to the third windings 226 in the sub-transformers 200 are all connected in parallel, and the second windings 225 in the plurality of sub-transformers 200 are all connected in series, to implement a boost function. In another embodiment, the first winding 224 and the third winding 226 may be primary-side windings, and the second winding 225 is a secondary-side winding. In this case, the first windings 224 in the plurality of sub-transformers 200 are all connected in series, the third windings 226 in the plurality of sub-transformers 200 are all connected in series, and the third switch tubes 33 connected to the second windings 225 in the sub-transformers 200 are all connected in parallel, so as to implement a buck function.

The capacitor 40 may be located on the first winding 224 or the third winding 226, and the capacitor 40 may be connected between the first windings 224 of the plurality of sub-transformers 200. For example, when there are four sub-transformers 200, the capacitor 40 may be connected between the first winding 224 of the first sub-transformer 200 and the first winding 224 of the second sub-transformer 200; or the capacitor 40 may be connected between the first winding 224 of the second sub-transformer 200 and the first winding 224 of the third sub-transformer 200; or the capacitor 40 may be connected between the first winding 224 of the third sub-transformer 200 and the first winding 224 of the fourth sub-transformer 200.

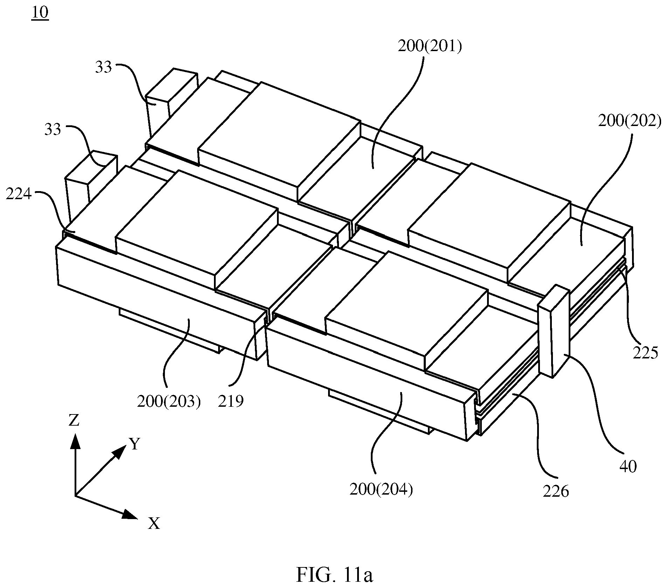

In another embodiment of this application, a difference from the embodiment shown in FIG. 8 lies in an arrangement manner of the plurality of sub-transformers 200, a fixed position of the third switch tube 33, and a fixed position of the capacitor 40. In the embodiment shown in FIG. 8, the plurality of sub-transformers 200 are arranged in the X direction. In this embodiment, as shown in FIG. 11a, the plurality of sub-transformers 200 are arranged in a rectangular array. For example, if there are four sub-transformers 200, the four sub-transformers 200 may be arranged in a 2×2 matrix. The plurality of sub-transformers 200 are arranged in two rows in the Y direction, and two sub-transformers 200 are arranged in each row in the X direction. For ease of description, the four sub-transformers 200 may be respectively named as a first sub-transformer 201, a second sub-transformer 202, a third sub-transformer 203, and a fourth sub-transformer 204, where the first sub-transformer 201 and the second sub-transformer 202 are arranged in a same row, namely, arranged in the X direction; the third sub-transformer 203 and the fourth sub-transformer 204 are located in a same row, namely, arranged in the X direction; the first sub-transformer 201 and the third sub-transformer 203 are located in a same column, and the second sub-transformer 202 and the fourth sub-transformer 204 are located in a same column.

As shown in FIG. 11a, the holes 219 in the two sub-transformers 200 in the X direction are in communication with each other. For example, the holes 219 of the first sub-transformer 201 and the second sub-transformer 202 are in communication with each other, and the holes 219 of the third sub-transformer 203 and the fourth sub-transformer 204 are in communication with each other. The holes 219 in the two sub-transformers 200 in the Y direction are parallel to each other. For example, the holes 219 of the first sub-transformer 201 and the third sub-transformer 203 are parallel to each other, and the holes 219 of the second sub-transformer 202 and the fourth transformer are parallel to each other. When the holes 219 of the first sub-transformer 201 and the second sub-transformer 202 are in communication with each other, first windings 224 of the two sub-transformers 200 may be located at a same layer. Therefore, the first windings 224 that are located at the same layer and that are interconnected may be manufactured as a whole. In other words, the first winding 224 is manufactured by using one PCB. In this way, assembly steps can be reduced, so as to simplify the process. Similarly, the holes 219 of the third sub-transformer 203 and the fourth sub-transformer 204 are in communication with each other, and the first windings 224 of the third sub-transformer 203 and the fourth sub-transformer 204 may also be manufactured by using one PCB.

As shown in FIG. 11a, two third switch tubes 33 are located on a first side of the plurality of sub-transformers 200, and are arranged in the Y direction. One third switch tube 33 is fastened to the first sub-transformer 201, and the third switch tube 33 is connected to the second winding 225 of the first sub-transformer 201. The other third switch tube 33 is fastened to the third sub-transformer 203, and the third switch tube 33 is connected to the second winding 225 of the third sub-transformer 203.

As shown in FIG. 11a, the capacitor 40 is located on a second side of the plurality of sub-transformers 200, where the second side is opposite to the first side, in other words, the capacitor 40 is located on a side opposite to the third switch tube 33. The capacitor 40 is fastened to the second sub-transformer 202 and the fourth sub-transformer 204, and the capacitor 40 is separately connected to the first winding 224 of the second sub-transformer 202 and the first winding 224 of the fourth sub-transformer 204. In this way, a current entering from the third switch tube 33 connected to the third sub-transformer 203 sequentially passes through the second winding 225 of the third sub-transformer 203, the second winding 225 of the fourth sub-transformer 204, the capacitor 40, the second winding 225 of the second sub-transformer 202, and the second winding 225 of the first sub-transformer 201, and flows out from the other third switch tube 33, where the second winding 225 in each sub-transformer may be in a U-shaped layout.

The following performs simulation calculation on the power module in this embodiment.

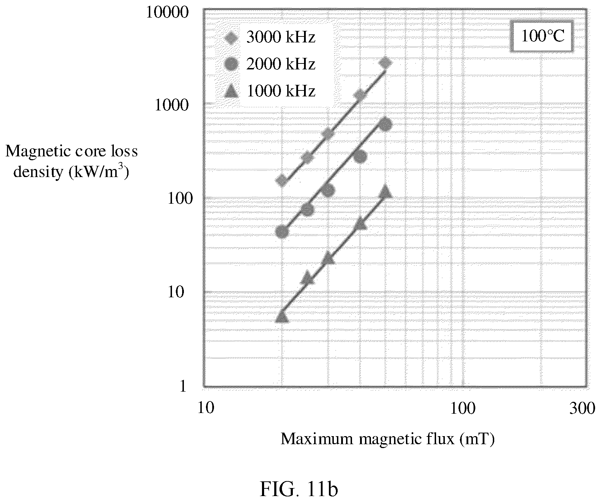

When working frequencies are 1000 kHz, 2000 kHz, and 3000 kHz, magnetic core loss density is calculated under different maximum magnetic fluxes. For a calculation result, refer to FIG. 11b. As shown in FIG. 11b, a horizontal coordinate represents the maximum magnetic flux, and a vertical coordinate represents the magnetic core loss density. It can be learned from FIG. 11b that, when working frequencies are the same, the magnetic core loss density increases as the maximum magnetic flux increases; and when the maximum magnetic fluxes are the same, the magnetic core loss density increases as the working frequency increases.

When the working frequencies are 1000 kHz, 2000 kHz, 500 kHz, and 800 kHz, the loss of the PCB winding, the magnetic core loss, and the magnetic core loss density are calculated separately.

The magnetic core loss may be calculated in the following manner:

It is assumed that a size of the sub-transformer 200 is 12×8×2.5 mm, and a size of the hole 219 of the magnetic core 21 in the Z direction is 0.5 mm. As shown in FIG. 4, a distance d1 between the hole 219 of the magnetic core 21 and the first surface 215 and a distance d2 between the hole 219 and the fourth surface 218 are both 1 mm.

According to the Faraday rule, the following formula may be obtained:

$$V = \frac{N \times 2 \times Bpk \times Ae \times f}{D}$$

In the formula, V represents a voltage at two ends of the first winding, N represents a quantity of turns of the first winding 224, and a value may be 1; Bpk represents the maximum magnetic flux, and a value may be 104 mT; $Ae$ represents a magnetic flux cross-sectional area of the magnetic core 21; $f$ represents a working frequency of the power supply module, and a value may be 1000 kHz, and when the power supply module is a switching power supply, the working frequency is a switching frequency; and D represents a conduction duty cycle of the first switch tube, and a value may be 0.5. According to the foregoing formula, $Ae$ may be calculated as 18 mm².

The magnetic core loss may be calculated according to the following formula:

$$Pc = Pvc \times Ve = Pvc \times 12 \times Ve$$

In the formula, $Pc$ represents the magnetic core loss, $Pvc$ represents the magnetic core loss density, and a value of may be 988 kW/m³; and Ve represents an effective size of the magnetic core. According to the foregoing two formulas, magnetic core loss Pc=0.213 W can be obtained.

When the working frequency is 1000 kHz, the loss of the PCB winding 22 is 1.66 W, the magnetic core loss is 0.21 W, a thickness of the PCB winding 22 is 0.1 mm, the maximum magnetic flux is 104 mT, alternating current resistance of the second winding 225 is 0.52 mohm, the magnetic core loss density is 988 kW/m³, and direct current resistance of the second winding 225 is 0.4 mohm.

When the working frequency is 2000 kHz, the loss of the PCB winding 22 is 2.08 W, the magnetic core loss is 0.174 W, the thickness of the PCB winding 22 is 0.28 mm, the maximum magnetic flux is 52 mT, the alternating current resistance of the second winding 225 is 0.65 mohm, the loss density of the magnetic core 21 is 806 kW/m³, and the direct current resistance of the second winding 225 is 0.5 mohm.

When the frequency is 800 kHz, the loss of the PCB winding 22 is 1.248 W, the loss of the magnetic core 21 is 0.526 W, the thickness of the PCB winding 22 is 0.13 mm, the maximum magnetic flux is 130 mT, the alternating current resistance of the second winding 225 is 0.39 mohm, the magnetic core loss density is 2435 kW/m³, and the direct current resistance of the second winding 225 is 0.3 mohm.

When the working frequency is 500 kHz, the loss of the PCB winding 22 is 1.04 W, the magnetic core loss is 1.22 W, the thickness of the PCB winding 22 is 0.16 mm, the maximum magnetic flux is 208 mT, the alternating current resistance of the second winding 225 is 0.325 mohm, the magnetic core loss density is 5667 kW/m³, and the direct current resistance of the second winding 225 is 0.25 mohm. It can be learned from the foregoing calculation results that a loss of the PCB winding is relatively low.

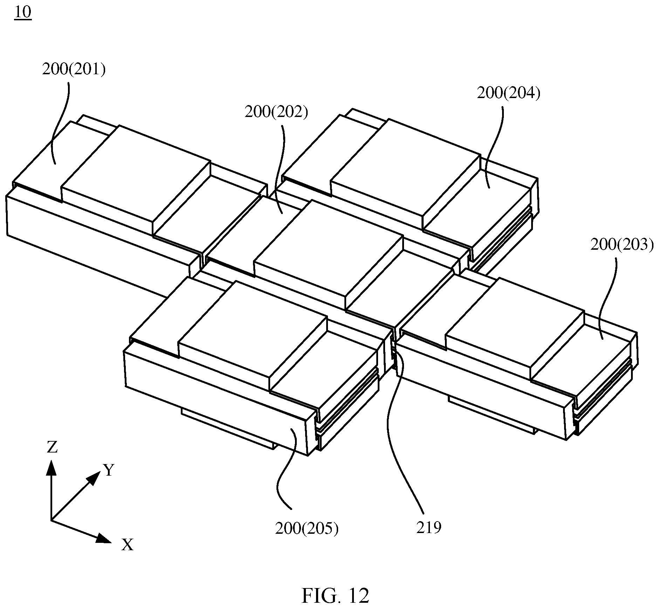

In another embodiment of this application, a difference from the embodiment shown in FIG. 8 lies in that the plurality of sub-transformers 200 are arranged in different manners. For example, in the embodiment shown in FIG. 8, the plurality of sub-transformers 200 are arranged in the X direction. In this embodiment, as shown in FIG. 12, the plurality of sub-transformers 200 are arranged in a cross-shaped array. In this way, a structure of the planar transformer 20 is more compact, and is applicable to a case in which a size in a direction of the power module is limited and larger mounting space cannot be provided for the planar transformer 20. In this embodiment, there may be five sub-transformers 200, which are respectively named as a first sub-transformer 201, a second sub-transformer 202, a third sub-transformer 203, a fourth sub-transformer 204, and a fifth sub-transformer 205. The first sub-transformer 201, the second sub-transformer 202, and the third sub-transformer 203 are arranged in the X direction, and the holes 219 of the first sub-transformer 201, the second sub-transformer 202, and the third sub-transformer 203 are all in communication with each other. The fourth sub-transformer 204 and the fifth sub-transformer 205 are respectively located on two sides of the second sub-transformer 202.

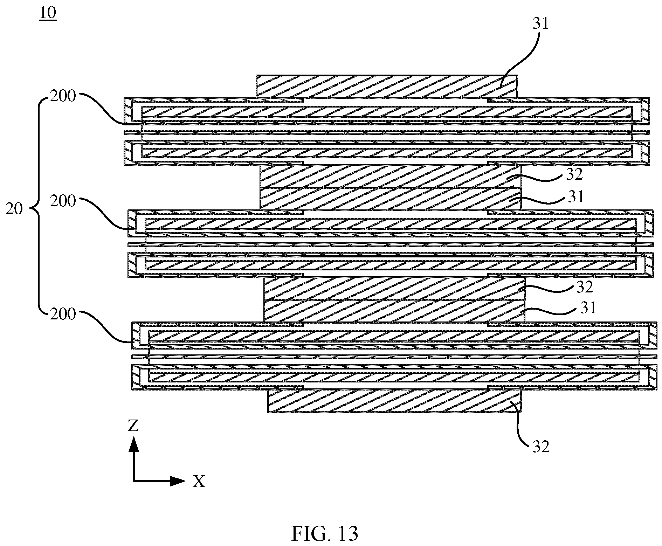

In another embodiment of this application, a difference from the embodiment shown in FIG. 8 lies in that the plurality of sub-transformers 200 are arranged in different manners. For example, in the embodiment shown in FIG. 8, the plurality of sub-transformers 200 are arranged in the X direction. In this embodiment, as shown in FIG. 13, the plurality of sub-transformers 200 are disposed in a stacked manner. For example, there are three sub-transformers 200, and the three sub-transformers 200 are stacked in the Z direction. In other words, the planar transformer 20 includes three layers of sub-transformers 200 in total, and there is one sub-transformer 200 at each layer. The structure is applicable to a case in which mounting space of a same layer in the power module is small. Each sub-transformer 200 is connected to one first switch tube 31 and one second switch tube 32. The sub-transformer 200 and the first switch tube 31 and the second switch tube 32 that are fastened to the sub-transformer 200 may form a power unit. Therefore, the plurality of sub-transformers 200 are disposed in a stacked manner, and this may also be understood as that a plurality of power units are disposed in a stacked manner.

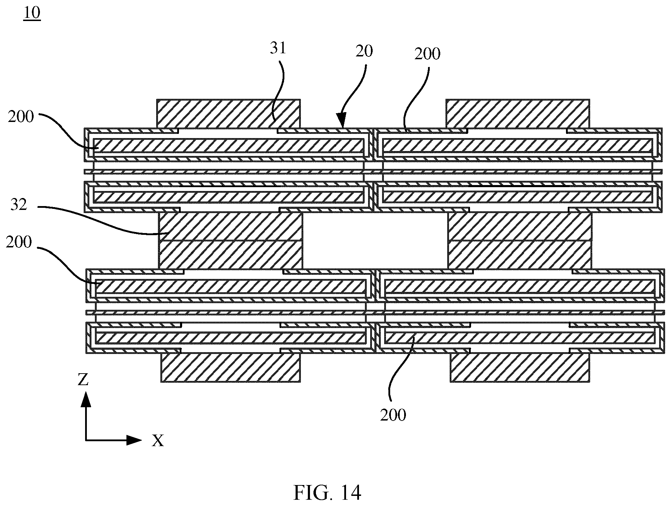

In another embodiment of this application, a difference from the embodiment shown in FIG. 8 lies in that the plurality of sub-transformers 200 are arranged in different manners. For example, in the embodiment shown in FIG. 13, the plurality of sub-transformers 200 are disposed in a stacked manner, and each layer of sub-transformer 200 includes one sub-transformer 200. In this embodiment, as shown in FIG. 14, the plurality of sub-transformers 200 are arranged into two layers, each layer includes a plurality of sub-transformers 200, and the plurality of sub-transformers 200 in each layer may be arranged in the X direction or arranged in a rectangular array. For example, when a required size of the power module is 48×16×5.4 mm³, an input voltage is 40 V to 60 V, an output voltage is 12 V, and maximum output power is 16 kW, when the size of the magnetic core 21 in the Z direction is 2.5 mm, the size of the first sub-switch tube 31 and the size of the second sub-switch tube 32 in the Z direction are both 1 mm, one sub-transformer 200 and the first switch tube 31 and the second switch tube 32 that are fastened to the sub-transformer 200 may form a power unit, and a size of each power unit is 12×8×2.5 mm. In this way, a two-layer structure may be used, and there are eight sub-transformers 200 at each layer, which are arranged into two rows, and there are four sub-transforms 200 in each row.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make modifications without departing from the purposes of this application and the protection scope of the claims, and all the modifications shall fall within the protection of this application.

**Claims**

**1.** A planar transformer, comprising a sub-transformer, wherein the sub-transformer comprises:

a magnetic core, wherein a hole is formed on a surface of the magnetic core; and
a printed circuit board PCB winding, wherein the PCB winding comprises a first winding and a second winding, the first winding is disposed around at least one part of the magnetic core, a part of the first winding is disposed on the surface of the magnetic core, the magnetic core and the part of the first winding disposed on the surface of the magnetic core are disposed in a stacked manner, a part of the first winding is located in the hole, and the second winding is disposed on the magnetic core, wherein
the first winding is one of a primary-side winding and a secondary-side winding, and the second winding is the other of the primary-side winding and the secondary-side winding.

2. The planar transformer according to claim 1, wherein the magnetic core comprises a first core body and a second core body that are disposed opposite to each other, and the hole is formed between the first core body and the second core body; and
the first winding is disposed around the first core body.

3. The planar transformer according to claim 2, wherein at least one part of the second winding is located in the hole.

4. The planar transformer according to claim 2 or 3, wherein the hole is a through hole, a part of the second winding is located in the hole, and two ends of the second winding extend out of the hole.

5. The planar transformer according to any one of claims 2 to 4, wherein the sub-transformer further comprises a third winding, the third winding is disposed around the second core body, a part of the third winding is disposed on a surface that is of the second core body and that is away from the first core body, and a part of the third winding is located in the hole.

6. The planar transformer according to claim 5, wherein the second winding is located between the first winding and the third winding.

7. The planar transformer according to any one of claims 2 to 6, wherein the hole is the through hole, and two ends of the first winding extend from two ends of the hole and are wound around the first core body.

8. The planar transformer according to claim 5 or 6, wherein the hole is the through hole, and two ends of the third winding extend from two ends of the hole and are wound around the second core body.

9. The planar transformer according to any one of claims 1 to 8, wherein there are a plurality of sub-transformers, and second windings of the plurality of sub-transformers are all connected in series.

10. The planar transformer according to claim 9, wherein the plurality of sub-transformers are located at a same layer and are sequentially arranged in a first direction, and holes in at least two of the plurality of sub-transformers are in communication with each other.

11. The planar transformer according to claim 9, wherein the plurality of sub-transformers are located at a same layer and are arranged in a rectangular array, holes in the plurality of sub-transformers in a first direction are all in communication with each other, holes in the plurality of sub-transformers in a second direction are all parallel to each other, and the second direction is perpendicular to the first direction.

12. The planar transformer according to claim 9, wherein the plurality of sub-transformers are located at a same layer and arranged in a cross-shaped array.

13. The planar transformer according to claim 9, wherein the plurality of sub-transformers are disposed in a stacked manner.

14. A power module, comprising the planar transformer according to any one of claims 1 to 13.

15. The power module according to claim 14, wherein the power module further comprises a first switch tube, a first electrode and a second electrode of the first switch tube are respectively connected to two ends of the first winding of the sub-transformer, the first switch tube is fastened to the first winding, and the first switch tube, a part of the first winding, and the magnetic core are disposed in a stacked manner.

16. The power module according to claim 14 or 15, wherein the sub-transformer further comprises the third winding; and
the power module further comprises a second switch tube, wherein a first electrode and a second electrode of the second switch tube are respectively connected to the two ends of the third winding, the second switch tube is fastened to the third winding, and the second switch tube, a part of the third winding, and the magnetic core are disposed in a stacked manner.

17. A power supply module, comprising the power module according to any one of claims 14 to 16.

18. An electronic device, comprising the power module according to claim 17.

FIG. 1a

FIG. 1b

10

30

20(200)

Z

Y

X

30

40

FIG. 2

200

21

Z
Y
X

224 225 226

22

FIG. 3

21

215  2110

d1

217

216

d2

218  2112  219

Z
X

FIG. 4

FIG. 5

FIG. 6

A-A

20

21    31(30)    11                    2245

2243

Z

Y

32(30)

FIG. 7

10

30

20

200                    200

Z
Y

X

30

30

40

FIG. 8

20

200                    200

Z
Y

X

FIG. 9

FIG. 10

10

33

33

224

200(201)

200(202)

200(203)    219

Z

Y

X

200(204)

226

225

40

FIG. 11a

FIG. 11b

10

200(201)

200(202)

200(204)

200(203)

Z

Y

X

200(205)

219

FIG. 12

FIG. 13

<u>10</u>

31  20  200

200

32

200

200

Z

X

FIG. 14

## INTERNATIONAL SEARCH REPORT

| International application No. |
| --- |
| **PCT/CN2023/096207** |

**A. CLASSIFICATION OF SUBJECT MATTER**

H01F 27/28(2006.01)i

According to International Patent Classification (IPC) or to both national classification and IPC

**B. FIELDS SEARCHED**

Minimum documentation searched (classification system followed by classification symbols)

IPC:H01F

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 磁芯, 空, 空心, 孔, 平面变压器, 铁芯, 弯折, 折叠, 重叠, 印刷电路板; coil, hollow, hole, planar transformer, core, bend, fold, overlap, print circuit board, pcb

**C. DOCUMENTS CONSIDERED TO BE RELEVANT**

| Category* | Citation of document, with indication, where appropriate, of the relevant passages | Relevant to claim No. |
| --- | --- | --- |
| A | CN 109378188 A (DONGGUAN DAZHONG ELECTRONICS CO., LTD.) 22 February 2019 (2019-02-22) <br> description, paragraphs 25-33, and figures 1-6 | 1-18 |
| A | CN 113782310 A (HUAWEI DIGITAL ENERGY TECHNOLOGIES CO., LTD.) 10 December 2021 (2021-12-10) <br> entire document | 1-18 |
| A | US 2009309684 A1 (DELTA ELECTRONICS, INC.) 17 December 2009 (2009-12-17) <br> entire document | 1-18 |
| A | US 5598327 A (BURR BROWN CORP.) 28 January 1997 (1997-01-28) <br> entire document | 1-18 |

☐ Further documents are listed in the continuation of Box C.    ☑ See patent family annex.

| | |
| --- | --- |
| \* Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **11 August 2023** | **15 August 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/096207**

| Patent document cited in search report | | | Publication date (day/month/year) | Patent family member(s) | | | Publication date (day/month/year) |
|---|---|---|---|---|---|---|---|
| CN | 109378188 | A | 22 February 2019 | CN | 208985839 | U | 14 June 2019 |
| CN | 113782310 | A | 10 December 2021 | | None | | |
| US | 2009309684 | A1 | 17 December 2009 | US | 7688171 | B2 | 30 March 2010 |
| | | | | TW | 200952002 | A | 16 December 2009 |
| | | | | TWI | 324351 | B | 01 May 2010 |
| US | 5598327 | A | 28 January 1997 | TW | 231358 | B | 01 October 1994 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210891919